# EUROPÄISCHE PATENTSCHRIFT

(11) **EP 1 601 026 B1**
(45) Veröffentlichungstag und Bekanntmachung des Hinweises auf die Patenterteilung: **28.11.2018**
(21) Anmeldenummer: 05007104.2
(22) Anmeldetag: 31.03.2005
(51) Int. Cl.: H01L 33/08, H01L 33/40, H01L 33/46, H01L 27/15

(54) **Optoelektronisches Halbleiterbauteil und Verfahren zu dessen Herstellung**
Optoelectronic semiconductor device and method for its production
Dispositif semi-conducteur optoélectronique et son procédé de fabrication

(30) Priorität: 28.05.2004 DE 102004026125
(43) Veröffentlichungstag der Anmeldung: 30.11.2005
(73) Patentinhaber: OSRAM Opto Semiconductors GmbH, 93055 Regensburg (DE)
(72) Erfinder: Stauss, Peter, 93186 Pettendorf (DE)
(74) Vertreter: Epping - Hermann - Fischer

(56) Entgegenhaltungen:
- EP-A2- 0 727 829
- EP-A2- 1 132 977
- EP-A2- 1 403 935
- JP-A- 2003 152 222
- US-A- 5 391 896
- US-A- 5 684 309
- US-A- 5 739 552
- US-A- 5 786 606
- US-A1- 2002 177 248
- US-A1- 2003 047 742
- US-A1- 2003 063 462
- US-A1- 2004 026 703

## Beschreibung

Die Erfindung betrifft ein optoelektronisches Bauteil. Darüber hinaus betrifft die Erfindung ein Verfahren zur Herstellung eines optoelektronischen Bauteils.

Die Druckschriften US 2002/177248 A1, EP 1132977 A2 und EP 1403935 A2 beschreiben jeweils ein optoelektronisches Bauteil. Die Druckschriften US 2003/047742 A1 und US 2004/026703 A1 betreffen jeweils eine Lichtquelle.
Die Druckschrift DE 198 195 43 A1 beschreibt eine zweifarbige Lichtemissions-Halbleitereinrichtung, die zwischen ihrer Vorderseite und ihrer Rückseite eine erste oberflächen-emittierende Lichtemissionsdiode mit einer ersten aktiven Zone, welche Strahlung in einer ersten Wellenlänge emittiert, und eine zweite oberflächen-emittierende Lichtemissionsdiode mit einer zweiten aktiven Zone, welche Strahlung in einer zweiten Wellenlänge emittiert, aufweist. Dabei ist zwischen beiden aktiven Zonen eine erste Reflexionsschicht angeordnet, die für die erste Wellenlänge reflektierend und für die zweite Wellenlänge durchlässig ist, und zwischen der zweiten aktiven Zone und der Rückseite ist eine zweite Reflexionsschicht angeordnet, die für die zweite Wellenlänge reflektierend ist.
Die Druckschrift US 5,391,896 beschreibt ein monolithisches, Vielfarben-optoelektronisches Bauteil, das ein Indium-Phosphit-Substrat mit einer Ober- und Unterseite aufweist, eine erste Zone, die auf die Oberfläche des Substrats aufgebracht ist, und eine zweite Zone, die auf die erste Zone aufgebracht ist. Die erste Zone ist bevorzugt auf Basis von GaInAsP, und die zweite Zone auf Basis von InP gebildet. Die beiden Zonen sind gitterangepasst gewachsen. Die zweite Zone weist eine größere Bandlücke als die erste Zone auf.

Zusätzlich können weitere Zonen mit jeweils größerer Bandlücke aufgebracht werden. Mit dem Bauteil kann gleichzeitig oder zu unterschiedlichen Zeiten Licht unterschiedlicher Farben ausgesandt und empfangen werden.
Es ist Aufgabe der vorliegenden Erfindung, ein optoelektronisches Bauteil anzugeben, das besonders vielseitig einsetzbar ist. Ferner ist es Aufgabe der Erfindung, ein Verfahren zur Herstellung eines solchen optoelektronischen Bauteils anzugeben.
Die Erfindung ist durch den Patentanspruch 1 und den Patentanspruch 10 definiert. Vorteilhafte Ausgestaltungen sind Gegenstand der abhängigen Patentansprüche.
Im Folgenden werden Teile der Beschreibung und Zeichnungen, die sich auf Ausführungsformen oder Ausführungsbeispiele beziehen, die nicht von den Ansprüchen abgedeckt sind, nicht als Ausführungsformen beziehungsweise Ausführungsbeispiele der Erfindung präsentiert, sondern als Beispiele, die zum Verständnis der Erfindung nützlich sind.
Es wird ein optoelektronisches Bauteil angegeben, das einen Schichtstapel aufweist, der wenigstens zwei aktive Zonen umfasst und einen Träger aufweist, der auf den Schichtstapel aufgebracht ist.

Die Schichten sind dabei auf ein Aufwachssubstrat epitaktisch abgeschieden. Die aktiven Zonen sind bevorzugt in vertikaler Richtung übereinander mit ihren Flachseiten aneinander angeordnet. Das heißt, bevorzugt sind die Schichten des Schichtstapels monolithisch integriert.

Bevorzugt ist der Schichtstapel eine Abfolge von Schichten, von der das Aufwachssubstrat nach Abschluss des epitaktischen Wachstums entfernt worden ist. Auf die dem ursprünglichen Aufwachssubstrat abgewandte Oberfläche des Schichtstapels ist ein Träger aufgebracht. Das bedeutet, bei dem Träger handelt es sich nicht um das ursprüngliche Aufwachssubstrat. Bauteile, die unter Entfernen des Aufwachssubstrats von einer epitaktisch gewachsenen Schichtenfolge hergestellt sind, werden oftmals auch mit dem Oberbegriff Dünnfilmschicht-Bauteile bezeichnet.
Ein Grundprinzip eines Dünnfilmschicht-Bauteils ist beispielsweise in I. Schnitzer et al., Appl. Phys. Lett. 63 (16), 18. Oktober 1993, Seiten 2174-2176, beschrieben, deren Offenbarungsgehalt bezüglich des Grundprinzips von Dünnfilmschicht-Bauteilen hiermit durch Rückbezug aufgenommen wird.
Beispielsweise ein Dünnfilm-Leuchtdiodenchip ist in guter Näherung ein Lambert'scher Oberflächenstrahler und eignet sich von daher besonders gut für die Anwendung in einem Scheinwerfer.
Besonders vorteilhaft ist, dass der Träger, verglichen mit dem Aufwachssubstrat, relativ frei gewählt werden kann. So kann der Träger hinsichtlich mancher Eigenschaften, wie etwa Leitfähigkeit oder Stabilität, für das Bauteil besser geeignet sein als verfügbare Aufwachssubstrate, die zur Herstellung hochwertiger, epitaktisch gewachsener Schichtenfolgen engen Einschränkungen unterliegen. So muss, um hochwertige epitaktische Schichten zu erhalten, das epitaktisch abgeschiedene Material beispielsweise gitterangepasst zum Aufwachssubstrat sein.
Bevorzugt zeichnet sich der auf dem Schichtstapel aufgebrachte Träger durch einen an den Schichtstapel angepassten thermischen Ausdehnungskoeffizienten aus.

Beispielsweise kann der Träger ein Halbleitermaterial wie Germanium, Gallium-Arsenid, Gallium-Nitrid, Silizium-Karbid oder andere Materialien wie Saphir, Molybdän oder Metalle enthalten. Zwischen dem aufgebrachten Träger und dem Schichtstapel ist eine metallhaltige Spiegelschicht angeordnet Ein metallhaltiger Spiegel, der beispielsweise Gold, Gold-Germanium, Silber, Aluminium oder Platin enthalten kann, zeichnet sich gegenüber einem Bragg-Spiegel beispielsweise durch eine geringere Richtungsabhängigkeit der Reflektivität aus. Auch lässt sich mit metallhaltigen Spiegeln eine höhere Reflektivität als mit Bragg-Spiegeln erreichen. Besonders bevorzugt enthält die Spiegelschicht eines der folgenden Materialien: Gold, Gold-Germanium.
In einer weiteren bevorzugten Ausführungsform des optoelektronischen Bauteils sind die aktiven Zonen übereinander, parallel oder im Wesentlichen parallel zum Träger angeordnet. Im Wesentlichen parallel heißt in diesem Zusammenhang, dass es beispielsweise während des epitaktischen Wachstums des Schichtstapels, der die aktiven Zonen umfasst, zu einem leicht schrägen Aufwachsen der Schichten übereinander kommen kann. Die aktiven Zonen sind in solch einem Fall nicht exakt parallel zum Träger angeordnet. Auch ist es möglich, dass der Träger nicht exakt plan auf dem Schichtstapel aufgebracht ist. Auch in diesem Fall wäre die Anordnung der aktiven Zonen nicht exakt parallel zum Träger. Außerdem sind weitere prozessbedingte Abweichungen von einer exakt parallelen Anordnung denkbar.

Wenigstens zwei aktive Zonen weisen eine gemeinsame Kontaktschicht auf. Das bedeutet, dass jeweils zwei aktive Zonen über eine gemeinsame Kontaktschicht elektrisch kontaktierbar sind. Die gemeinsame Kontaktschicht bildet dabei beispielsweise jeweils den p-seitigen Kontakt zweier benachbarter aktiver Zonen.

Die aktiven Zonen sind geeignet, elektromagnetische Strahlung in wenigstens zwei verschiedenen Wellenlängen zu erzeugen.
Besonders bevorzugt kann jede aktive Zone elektromagnetische Strahlung einer unterschiedlichen, d. h. von den anderen aktiven Zonen verschiedenen Wellenlänge erzeugen. Die aktiven Zonen können beispielsweise geeignet sein, Licht im sichtbaren oder im nicht sichtbaren Wellenlängenbereich des elektromagnetischen Spektrums zu erzeugen. Auch ist es möglich, dass ein Teil der aktiven Zonen Licht im sichtbaren Bereich und ein anderer Teil Licht im nicht sichtbaren, beispielsweise infraroten Spektralbereich erzeugen kann.
Bevorzugt strahlen die aktiven Zonen das in ihnen erzeugte Licht in einer Hauptabstrahlrichtung, die senkrecht oder im Wesentlichen senkrecht zum Träger steht und vom Träger weg gerichtet ist, ab.
Dazu können die aktiven Zonen beispielsweise einen pn-Übergang, eine Doppelheterostruktur, einen Einfach-Quantentopf oder besonders bevorzugt eine Mehrfach-Quantentopfstruktur (MQW) aufweisen. Solche Strukturen sind dem Fachmann bekannt und werden daher an dieser Stelle nicht näher erläutert. Beispiele für MQW-Strukturen sind in den Druckschriften WO 01/39282, WO 98/31055, US 5,831,277, EP 1 017 113 und US 5,684,309 beschrieben.

Die Bezeichnung Quantentopfstruktur umfasst im Rahmen der Anmeldung jegliche Struktur, bei der Ladungsträger durch Einschluss ("confinement") eine Quantisierung ihrer Energiezustände erfahren. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.
Besonders bevorzugt umfasst der Schichtstapel beispielsweise zwei aktive Zonen, die geeignet sind Licht unterschiedlicher Wellenlänge zu erzeugen. Das heißt eine erste aktive Zone erzeugt elektromagnetische Strahlung einer ersten Wellenlänge und eine zweite aktive Zone erzeugt elektromagnetische Strahlung einer zweiten Wellenlänge.
In einer weiteren bevorzugten Ausführungsform des optoelektronischen Bauteils ist eine aktive Zone für die elektromagnetische Strahlung der unter ihr angeordneten aktiven Zonen transparent. Dies kann beispielsweise dadurch realisiert sein, dass die Bandlücken der aktiven Zonen vom Träger in Hauptabstrahlrichtung nach oben größer werden. Das bedeutet angewandt auf alle aktiven Zonen im Schichtstapel, dass je näher sich eine aktive Zone am Träger befindet, desto langwelliger ist die von ihr erzeugte elektromagnetische Strahlung.

Als besonders vorteilhaft erweist sich dabei die vertikale Stapelung und damit die räumliche Nähe von strahlungserzeugenden aktiven Zonen, da durch die Abfolge der strahlungserzeugenden Zonen in Hauptabstrahlrichtung ein gemeinsames optisches Element mit einem gemeinsamen Fokus für alle aktiven Zonen verwendet werden kann. Das optische Element bietet vorteilhaft die Möglichkeit, die Abstrahlcharakteristik des optoelektronischen Bauteils je nach Anwendungsgebiet des Bauteils anzupassen. Insbesondere kann das optische Element dabei als refraktive oder diffraktive Optik gestaltet sein.

Die aktiven Zonen sind unabhängig voneinander kontaktierbar. Das heißt, die aktiven Zonen können unabhängig voneinander elektrisch betrieben werden. Beispielsweise ist es dadurch möglich, dass die aktiven Zonen zu jeweils unterschiedlichen Zeiten elektromagnetische Strahlung erzeugen können. Je nachdem, Licht welcher Wellenlänge erzeugt werden soll, kann die entsprechende aktive Zone elektrisch kontaktiert werden, sodass die gewünschte Strahlung erzeugt wird.
In einer weiteren bevorzugten Ausführungsform sind wenigstens zwei aktive Zonen zur gleichzeitigen Erzeugung elektromagnetischer Strahlung geeignet. Dadurch ergibt sich vorteilhaft, dass durch beispielsweise additive Farbmischung, der in den einzelnen aktiven Zonen erzeugten elektromagnetischen Strahlung, Mischlicht erzeugt werden kann.
Besonders vorteilhaft kann die von den aktiven Zonen emittierte elektromagnetische Strahlung derart gewählt werden, dass als Mischlicht weißes Licht erzeugt wird. Beispielsweise bei zwei aktiven Zonen kann die näher am Träger gelegene so gewählt werden, dass sie Licht einer ersten, größeren Wellenlänge abstrahlt, und die vom Träger weiter entfernte Zone kann so gewählt werden, dass sie Licht einer zweiten, kleineren Wellenlänge abstrahlt, wobei die beiden Wellenlängen so gewählt werden können, dass sich als Mischfarbe weißes Licht ergibt.
Besonders bevorzugt können alle aktiven Zonen gleichzeitig elektromagnetische Strahlung erzeugen.

Mehrere Spiegelschichten sind übereinander angeordnet. Dabei sind die Spiegelschichten so gewählt dass sie jeweils nur die Strahlung reflektieren, die in einer bestimmten aktiven Zone erzeugt worden ist, sodass jeder Wellenlänge der in den aktiven Zonen erzeugten Strahlung wenigsten eine Spiegelschicht zugeordnet ist.
In einer besonders bevorzugten Ausführungsform handelt es sich bei dem optoelektronischen Bauteil um eine Vielfarben-Leuchtdiode. Das heißt, die aktiven Zonen stellen eine vertikale Abfolge von Leuchtdioden dar, die übereinander in Hauptabstrahlrichtung angeordnet sind.

Ein konkretes Beispiel ist eine Kombination von Blinker und Rückleuchte in einem gemeinsamen abbildenden System, das beispielsweise durch ein gemeinsames optisches Element gegeben sein kann. Auch die Anwendung in Signalanlagen, wie beispielsweise Ampeln, ist denkbar. Hier kann die gelbe Lampe in die rote integriert werden. Besonders vorteilhaft erweist sich die vertikale Stapelung der aktiven Zonen in Hauptabstrahlrichtung, weil sie, verglichen mit einer horizontalen Anordnung von Leuchtdioden, besonders platzsparend ist.
Es wird darüber hinaus ein Verfahren zur Herstellung eines optoelektronischen Bauteils gemäß Patentanspruch 10 angegeben, das die folgenden Schritte umfasst:
(a) epitaktisches Abscheiden eines Schichtstapels, umfassend wenigstens zwei aktive Zonen auf einem Substrat-Wafer,
(b) Aufbringen eines Trägers auf die dem Substrat-Wafer gegenüberliegende Oberfläche des Schichtstapels,
(c) Entfernen des Substrats.
Vorzugsweise erfolgen die Verfahrenschritte in der angegebenen Reihenfolge.
Besonders vorteilhaft erweist sich bei diesem Verfahren, dass eine Vielzahl der beschriebenen optoelektronischen Bauteile im Wafer-Verbund gleichzeitig hergestellt werden kann. Dadurch können die Bauteile besonders schnell und kostengünstig produziert werden.

Vor Schritt (b) des Verfahrens wird eine Spiegelschicht auf die dem Wafer-Substrat gegenüberliegende Oberfläche des Schichtstapels aufgebracht. Die Spiegelschicht kann beispielsweise durch Sputtern oder Aufdampfen aufgebracht werden.
Im Folgenden werden das hier beschriebene optoelektronische Bauteil und das Verfahren zur Herstellung eines solchen Bauteils anhand von Ausführungsbeispielen und den dazu gehörigen Figuren näher erläutert.
Figur 1 zeigt einen Querschnitt durch ein nicht erfindungsgemäßes Bauteil anhand einer Prinzipienskizze.
Figuren 2a bis 2e zeigen ein nicht erfindungsgemäßes Verfahren anhand von Prinzipienskizzen.

In den Beispielen und Figuren sind gleiche oder gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

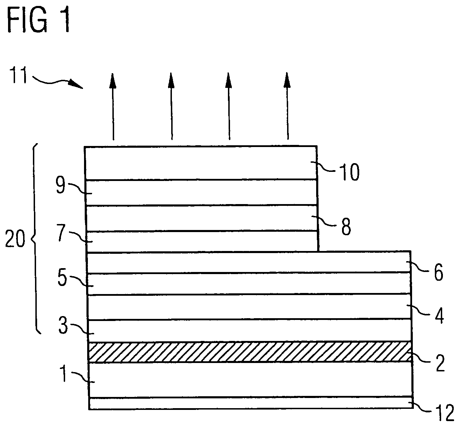

Figur 1 zeigt ein Beispiel eines nicht erfindungsgemäßen optoelektronisches Baiteils. Auf dem Träger 1 ist eine Spiegelschicht 2 aufgebracht, welcher der Schichtstapel 20 nachfolgt. Der Träger 1 kann beispielsweise Germanium, Gallium-Arsenid, Silizium-Karbid, Molybdän oder ein anderes geeignetes Material enthalten. Vorteilhafterweise ist sein thermischer Ausdehnungskoeffizient dem des Schichtstapels 20 angepasst, sodass die während des Betriebs des optoelektronischen Bauteils entstehende Wärme nicht zu einer mechanischen Belastung des Bauteils an der Schnittstelle zwischen Träger 1 und Schichtstapel 20 führt. Weiter zeichnet sich der Träger 1 vorteilhaft durch eine gute Wärmeleiteigenschaft aus. So kann die im Bauteil erzeugte Wärme schnell an die Umgebung abgeführt werden. Dies erhöht die Lebensdauer des Bauteils und erlaubt den Betrieb des Bauteils bei höheren Leistungen.
Die Spiegelschicht 2 enthält bevorzugt Gold oder Gold-Germanium. Sie ist geeignet, die im Bauteil erzeugte Strahlung zu reflektieren. Die Spiegelschicht 2 zeichnet sich dabei besonders durch ihre hohe Reflektivität aus. Dadurch erhöht sich vorteilhaft die Abstrahlleistung des Bauteils, da keine oder kaum Strahlung durch beispielsweise Absorption im Träger 1 verloren gehen kann. Bevorzugt ist die Spiegelschicht 2 auf den Träger 1 aufgedampft oder aufgesputtert. Träger 1 und Spiegelschicht 2 sind auf den Schichtstapel 20 geklebt, gelötet oder gebondet.

Im hier beschriebenen Beispiel des optoelektronischen Bauteils umfasst der Schichtstapel 20 zwei aktive Zonen. Der Aufbau des Schichtstapels 20 ist dabei wie folgt: Der Spiegelschicht 2 folgt eine n-Mantelschicht 3, die beispielsweise n-dotiertes InGaP enthält, nach. Die n-Mantelschicht 3 sorgt dabei für ein Confinement der Ladungsträger in der ersten aktiven Zone 4. Ihr folgt die erste aktive Zone 4, die geeignet ist, elektromagnetische Strahlung einer bestimmten ersten Wellenlänge zu erzeugen.
Die aktive Zone 4 kann einen pn-Übergang, eine Doppelheterostruktur, einen Einfach-Quantentopf oder besonders vorteilhaft eine Mehrfach-Quantentopfstruktur enthalten. Beispielsweise enthält die erste aktive Zone 4 InGaAlP. Ihr folgt eine erste p-Mantelschicht 5 nach, die beispielsweise p-dotiertes InGaAlP enthält. Auf die erste p-Mantelschicht 5 ist eine p-Kontaktschicht 6 aufgebracht.

Über diese p-Kontaktschicht 6 wird sowohl die erste aktive Zone 4, als auch die nachfolgende zweite aktive Zone 8 p-seitig elektrisch kontaktiert. Vorteilhaft ist sie für die in der ersten aktiven Zone 4 erzeugte elektromagnetische Strahlung transparent und weist eine für die Kontaktierung der beiden aktiven Zonen ausreichende Leitfähigkeit auf. Die p-Kontaktschicht 6 enthält dafür beispielsweise InGaAlP mit einem Aluminium-Anteil zwischen 45% und 55%, bevorzugt von ca. 50 % oder AlGaAs mit einem Aluminium-Anteil zwischen 55% und 65%, bevorzugt mit 60 %-igem Aluminium-Anteil. Mittels beispielsweise eines selektiven Ätzprozesses ist die p-Kontaktschicht 6 so weit freigelegt, dass ein für den Betrieb des Bauteils ausreichendes elektrisches Kontaktieren der aktiven Zonen über diese p-Kontaktschicht 6 möglich ist.

Der p-Kontaktschicht 6 folgt eine zweite p-Mantelschicht 7 nach, die beispielsweise p-dotiertes InGaAlP enthält. Ihr nachfolgend ist die zweite aktive Zone 8 angeordnet. Diese zweite aktive Zone 8 kann im Aufbau der ersten aktiven Zone 4 ähnlich sein und erzeugt bevorzugt elektromagnetische Strahlung einer zweiten Wellenlänge. Die zweite Wellenlänge ist dabei vorteilhaft kleiner als die erste Wellenlänge, d. h. die zweite aktive Zone weist bevorzugt eine größere Bandlücke als die erste aktive Zone auf, sodass die in der ersten aktiven Zone 4 erzeugte langwelligere elektromagnetische Strahlung die zweite aktive Zone 8 ohne absorbiert zu werden durchdringen kann.

Auf die zweite aktive Zone 8 folgt eine zweite n-Mantelschicht 9 nach, die beispielsweise n-dotiertes InGaAlP enthält.
Der Schichtstapel 20 wird an seiner Ober- und Unterseite jeweils durch eine erste n-Kontaktschicht 10 bzw. eine zweite n-Kontaktschicht 12 abgeschlossen. Die erste n-Kontaktschicht 10 ist dabei vorteilhaft für die von den aktiven Zonen emittierte Strahlung, die in eine Hauptabstrahlrichtung 11 abgestrahlt wird, transparent. Die erste n-Kontaktschicht 10 kann beispielsweise durch ein seitlich auf die Oberfläche aufgebrachtes Bondpad kontaktiert sein. Das heißt, das Bondpad ist zum Beispiel in einer Ecke auf der Oberseite der n-Kontaktschicht 10 angeordnet.

Ein zweites nicht erfindungsgemäßes Bespiel unterscheidet sich vom ersten Beispiel lediglich darin, dass der Schichtstapel 20 auf Basis eines InGaAs-Systems aufgebaut ist, d. h. die Mantelschichten enthalten geeignet dotiertes InAlGaAs und die aktiven Zonen geeignet dotiertes InGaAs. Die gemeinsame p-Kontaktschicht 6 enthält beispielsweise InAlGaAs mit einem geeignet hohen Aluminium-Anteil. Vorteilhaft erweist sich bei diesem Ausführungsbeispiel, dass elektromagnetische Strahlung im infraroten Bereich von den aktiven Zonen abgestrahlt werden kann.
Vorteilhaft sind auch weitere Materialsysteme zur Bildung der beschriebenen Bauteile geeignet. Der Fachmann kann, je nach den Einsatzerfordernissen an das Bauteil, geeignete Materialien auswählen. Beispielsweise kann die Materialwahl dabei von den gewünschten Wellenlängen, die von den aktiven Zonen emittiert werden sollen, bestimmt sein. Außerdem ist es in den beschriebenen Beispielen möglich, die Schichtfolge dahingehend abzuändern, dass die aktiven Zonen durch eine gemeinsame n-Kontaktschicht statt einer gemeinsamen p-Kontaktschicht kontaktiert werden.

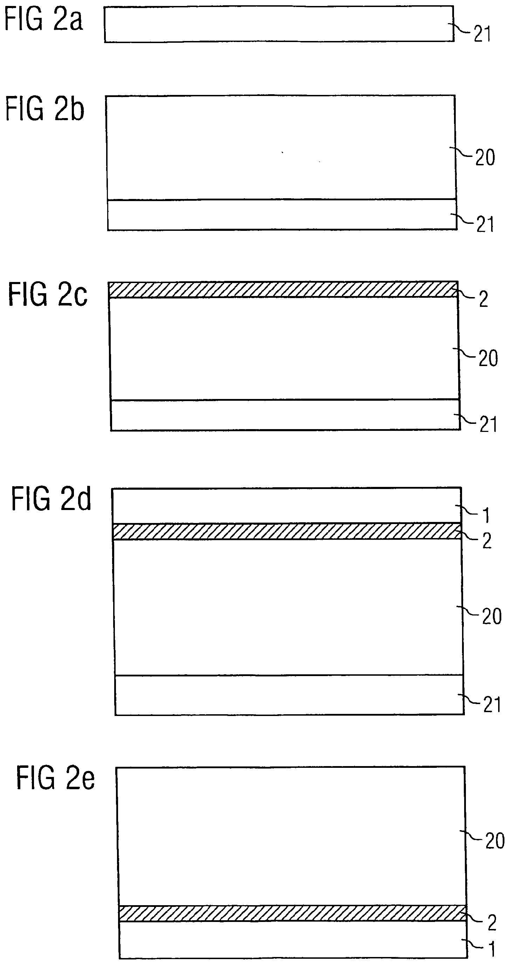

Die Figuren 2a bis 2e zeigen ein nicht erfindungsgemäßes Verfahren zur Herstellung des beschriebenen Beispiels eines optoelektronischen Bauteils. Zunächst wird, wie Figur 2a zeigt, ein Substrat-Wafer 21 zur Verfügung gestellt. Je nach Materialsystem, in dem der Schichtstapel 20 gebildet werden soll, kann es sich bei dem Substratwafer um beispielsweise einen GaAs-, einen InP- oder einen SiC-Wafer handeln.
Auf dem Substrat-Wafer 21 wird der Schichtstapel 20, umfassend eine gewünschte Anzahl von aktiven Zonen, epitaktisch abgeschieden (siehe Figur 2b).
Auf die dem Substrat-Wafer 21 abgewandte Oberfläche des Schichtstapels 20 wird im Folgenden eine Spiegelschicht 2 abgeschieden (Figur 2c). Dies kann beispielsweise durch Aufdampfen oder Sputtern geschehen. Bevorzugt enthält die Spiegelschicht 2 dabei ein Metall.
Figur 2d zeigt das Befestigen des Trägers 1 auf die dem Substrat-Wafer 21 abgewandte Oberfläche der Anordnung aus Schichtstapel 20 und Spiegelschicht 2. Das Aufbringen des Trägers 1 erfolgt dabei vorteilhaft mittels einer Lotverbindung, einer Klebeverbindung oder besonders vorteilhaft mittels eines Waferbonding-Verfahrens.
Nachfolgend (Figur 2e) wird der Substrat-Wafer 21 von dem Schichtstapel 20 entfernt. Zum Entfernen eignen sich beispielsweise lasergestützte Verfahren, wie etwa ein Laser-Ablationsverfahren, mechanische Methoden wie Abschleifen oder Ätzverfahren.
In weiteren Verfahrensschritten wird die Anordnung vereinzelt, es werden n-Kontaktschichten aufgebracht und die gemeinsamen Kontaktschichten der aktiven Zonen werden beispielsweise mittels selektiven Ätzes freigelegt. Die Reihenfolge dieser Verfahrensschritte kann dabei vorteilhaft frei gewählt werden.

## Patentansprüche

1. Optoelektronisches Bauteil, aufweisend
- einen Schichtstapel (20), der wenigstens zwei aktive Zonen (4,8) umfasst und einen Träger (1) aufweist, der auf den Schichtstapel aufgebracht ist,
- eine metallhaltige Spiegelschicht (2), die zwischen dem Schichtstapel (20) und dem Träger (1) angeordnet ist,
- wenigstens eine weitere Spiegelschicht, wobei
- jeweils zwei aktiven Zonen (4,8) durch eine gemeinsame Kontaktschicht (6) kontaktierbar sind,
- die aktiven Zonen (4,8) geeignet sind elektromagnetische Strahlung in wenigstens zwei verschiedenen Wellenlängen zu erzeugen,
- die aktiven Zonen (4,8) unabhängig kontaktierbar sind,
- die metallhaltige Spiegelschicht (2) und die wenigstens eine weitere Spiegelschicht übereinander angeordnet sind, **dadurch gekennzeichnet, dass**
- die metallhaltige Spiegelschicht (2) und die wenigstens eine weitere Spiegelschicht so beschaffen sind, dass sie jeweils nur die Strahlung reflektieren, die in einer bestimmten aktiven Zone (4,8) erzeugt worden ist, sodass jeder Wellenlänge der in den aktiven Zonen (4,8) erzeugten Strahlung wenigstens eine Spiegelschicht zugeordnet ist.

2. Optoelektronisches Bauteil nach Anspruch 1,
bei dem die Spiegelschicht (2) wenigstens eines der folgenden Materialien enthält: Au, AuGe.

3. Optoelektronisches Bauteil nach einem der Ansprüche 1 bis 2,
bei dem die aktiven Zonen (4,8) parallel zum Träger (1) übereinander angeordnet sind.

4. Optoelektronisches Bauteil nach Anspruch 1,
bei dem eine aktive Zone (8) für die elektromagnetische Strahlung der unter ihr angeordneten aktiven Zonen (4) transparent ist.

5. Optoelektronisches Bauteil nach einem der Ansprüche 1 bis 4,
bei dem wenigstens zwei aktive Zonen (4,8) zur gleichzeitigen Erzeugung elektromagnetischer Strahlung geeignet sind.

6. Optoelektronisches Bauteil nach einem der Ansprüche 1 bis 5,
das eine Vielfarben-Leuchtdiode ist.

7. Optoelektronisches Bauteil nach einem der Ansprüche 1 bis 6,
bei dem die Schichten des Schichtstapels (20) monolithisch integriert sind.

8. Optoelektronisches Bauteil nach einem der Ansprüche 1 bis 7,
bei dem das Aufwachssubstrat (21) gedünnt ist.

9. Optoelektronisches Bauteil nach einem der Ansprüche 1 bis 7,
bei dem das Aufwachssubstrat entfernt (21) ist.

10. Verfahren zur Herstellung eines optoelektronischen Bauteils, aufweisend die folgenden Schritte:
(a) epitaktisches Abscheiden eines Schichtstapels (20), umfassend wenigstens zwei aktive Zonen (4, 8) und eine Kontaktschicht (6), auf einen Substrat-Wafer (21),
(b) Aufbringen eines Trägers (1) auf die dem Substrat-Wafer (21) gegenüberliegende Oberfläche des Schichtstapels (20),
(c) Entfernen des Substrat-Wafers (21), wobei
- die zwei aktiven Zonen (4,8) durch die Kontaktschicht (6) kontaktierbar sind,
- die aktiven Zonen (4,8) geeignet sind, elektromagnetische Strahlung in wenigstens zwei verschiedenen Wellenlänge zu erzeugen,
- die aktiven Zonen (4,8) unabhängig kontaktierbar sind,
- vor dem Schritt (b) eine metallhaltige Spiegelschicht (2) auf die dem Substrat-Wafer (21) gegenüberliegende Oberfläche des Schichtenstapels (20) angeordnet wird,
- wenigstens eine weitere Spiegelschicht so angeordnet wird, dass die metallhaltige Spiegelschicht (2) und die wenigstens eine weitere Spiegelschicht übereinander angeordnet sind,
**dadurch gekennzeichnet, dass**
- die metallhaltige Spiegelschicht (2) und die wenigstens eine weitere Spiegelschicht so beschaffen sind, dass sie jeweils nur die Strahlung reflektieren, die in einer bestimmten aktiven Zone (4, 8) erzeugt worden ist, sodass jeder Wellenlänge der in den aktiven Zonen (4,8) erzeugten Strahlung wenigstens eine Spiegelschicht zugeordnet ist.

## Claims

1. Optoelectronic device comprising
- a layer stack (20) comprising at least two active zones (4,8) and having a support (1) applied to the layer stack,
- a metal-containing mirror layer (2) disposed between the layer stack (20) and the support (1),
- at least one further mirror layer, wherein
- two active zones (4,8) can each be contacted by a common contact layer (6),
- the active zones (4,8) are suitable for generating electromagnetic radiation in at least two different wavelengths,
- the active zones (4,8) can be contacted independently,
- the metal-containing mirror layer (2) and the at least one further mirror layer are arranged one above another,
**characterized in that**
- the metal-containing mirror layer (2) and the at least one further mirror layer are configured such that they each reflect only the radiation which has been generated in a certain active zone (4,8), so that at least one mirror layer is associated with each wavelength of the radiation generated in the active zones (4,8).

2. Optoelectronic device according to claim 1,
in which the mirror layer (2) contains at least one of the following materials: Au, AuGe.

3. Optoelectronic device according to any of claims 1 to 2,
in which the active zones (4, 8) are arranged one above the other parallel to the carrier (1).

4. Optoelectronic device according to claim 1,
in which an active zone (8) is transparent to the electromagnetic radiation of the active zones (4) arranged below it.

5. Optoelectronic device according to any of claims 1 to 4,
in which at least two active zones (4,8) are suitable for the simultaneous generation of electromagnetic radiation.

6. Optoelectronic device according to any of claims 1 to 5, which is a multicolor light-emitting diode.

7. Optoelectronic device according to any of claims 1 to 6,
in which the layers of the layer stack (20) are monolithically integrated.

8. Optoelectronic device according to any of claims 1 to 7,
in which the growth substrate (21) is thinned.

9. Optoelectronic device according to any of claims 1 to 7, wherein the growth substrate is removed (21).

10. A method of manufacturing an optoelectronic device comprising the following steps:
(a) epitaxially depositing a layer stack (20) comprising at least two active zones (4,8) and a contact layer (6) onto a substrate wafer (21),
(b) applying a support (1) to the surface of the layer stack (20) opposite the substrate wafer (21),
(c) removing the substrate wafer (21), wherein
- the two active zones (4,8) can be contacted by the contact layer (6),
- the active zones (4,8) are configured to generate electromagnetic radiation in at least two different wavelengths,
- the active zones (4,8) can be contacted independently,
- before step (b) a metal-containing mirror layer (2) is arranged on the surface of the layer stack (20) opposite the substrate wafer (21)
- at least one further mirror layer is arranged such that the metal-containing mirror layer (2) and the at least one further mirror layer are arranged one above another,
**characterized in that**
- the metal-containing mirror layer (2) and the at least one further mirror layer are configured such that they each reflect only the radiation which has been generated in a certain active zone (4,8), so that at least one mirror layer is associated with each wavelength of the radiation generated in the active zones (4,8).

## Revendications

1. Composant optoélectronique présentant
- une pile de couches (20), qui comporte au moins deux zones actives (4,8) et un support (1), qui est appliqué sur la pile de couches,
- une couche miroir métallique (2), qui est disposée entre la pile de couches (20) et le support (1),
- au moins une autre couche miroir, dans lequel
- deux zones actives (4,8) peuvent chacune être contactées par une couche de contact commune (6),,
- les zones actives (4,8) étant adéquates pour produire du rayonnement électromagnétique dans au moins deux longueurs d'ondes différentes,
- les zones actives (4,8) peuvent être contactées indépendamment,
- la couche miroir métallique (2) et au moins l'une des autres couches miroirs étant disposées l'une au-dessus de l'autre, **caractérisé en ce que**
- la couche miroir métallique (2) et au moins l'une des autres couches miroirs sont conçues afin qu'elles réfléchissent respectivement seulement le rayonnement qui a été généré dans une certaine zone active (4,8), afin que chaque longueur d'onde du rayonnement généré dans les zones actives (4,8) soit affectée au moins à une couche miroir.

2. Composant optoélectronique selon la revendication 1,
pour lequel la couche miroir (2) contient au moins un des matériaux suivants : Au, AuGe.

3. Composant optoélectronique selon une quelconque des revendications 1 à 2,
pour lequel les zones actives (4, 8) sont disposées l'une au-dessus de l'autre parallèlement au support (1).

4. Composant optoélectronique selon la revendication 1,
pour lequel une zone active (8) est transparente pour le rayonnement électromagnétique des zones actives (4) disposées au-dessous d'elle.

5. Composant optoélectronique selon une quelconque des revendications 1 à 4,
pour lequel au moins deux zones actives (4, 8) sont adéquates pour la production simultanée de rayonnement électromagnétique.

6. Composant optoélectronique selon une quelconque des revendications 1 à 5,
qui est une diode luminescente multicolore.

7. Composant optoélectronique selon une quelconque des revendications 1 à 6,
pour lequel les couches de la pile de couches (20) sont intégrées monolithiquement.

8. Composant optoélectronique selon une quelconque des revendications 1 à 7,
pour lequel le substrat d'épitaxie (21) est aminci.

9. Composant optoélectronique selon une quelconque des revendications 1 à 7,
pour lequel le substrat d'épitaxie (21) est retiré.

10. Procédé en vue de la fabrication d'un composant optoélectronique, présentant les étapes de :
(a) déposition par épitaxie d'une pile de couches (20), comportant au moins deux zones actives (4, 8) et une couche de contact (6) sur une tranche de substrat (21),
(b) application d'un support (1) sur la surface de la pile de couches (20) se trouvant en face de la tranche de substrat (21),
(c) retrait de la tranche de substrat (21), dans lequel
- les deux zones actives (4, 8) peuvent être contactées par la couche de contact (6),
- les zones actives (4, 8) étant adéquates pour produire du rayonnement électromagnétique dans au moins deux longueurs d'ondes différentes,
- les zones actives (4, 8) peuvent être contactées indépendamment,
- avant l'étape (b), une couche miroir métallique (2) étant disposée sur la surface de la pile de couches (20) se trouvant en face de la tranche de substrat (21),
- au moins l'une des autres couches miroirs étant disposée de manière à ce que la couche miroir métallique (2) et au moins l'une des autres couches miroirs étant disposées l'une au-dessus de l'autre,
**caractérisé en ce que**
- la couche miroir métallique (2) et au moins l'une des autres couches miroirs sont conçues afin qu'elles réfléchissent respectivement seulement le rayonnement qui a été généré dans une certaine zone active (4,8), afin que chaque longueur d'onde du rayonnement généré dans les zones actives (4,8) soit affectée au moins à une couche miroir.
